# EUROPÄISCHE PATENTSCHRIFT

(11) **EP 1 442 645 B1**
(45) Veröffentlichungstag und Bekanntmachung des Hinweises auf die Patenterteilung: **27.09.2006**
(21) Anmeldenummer: 02795057.5
(22) Anmeldetag: 29.10.2002
(51) Int. Cl.: H05K 13/00

(54) **VERFAHREN UND VORRICHTUNG ZUM EINBRINGEN VON FLACHEN SUBSTRATEN IN EINEN AUFNAHMEBEHÄLTER**
METHOD AND DEVICE FOR THE INSERTION OF PLANAR SUBSTRATES INTO A RECEIVING CONTAINER
PROCEDE ET DISPOSITIF D'INSERTION DE SUBSTRATS PLATS DANS UN RECEPTACLE

(30) Priorität: 05.11.2001 DE 10154889
(43) Veröffentlichungstag der Anmeldung: 04.08.2004
(73) Patentinhaber: Gebr. Schmid GmbH & Co., 72238 Freudenstadt (DE)
(72) Erfinder: KAPPLER, Heinz, 72280 Dornstetten-Aach (DE)
(74) Vertreter: Patentanwälte Ruff, Wilhelm, Beier, Dauster & Partner
(86) Internationale Anmeldenummer: PCT/EP2002/012038
(87) Internationale Veröffentlichungsnummer: WO 2003/041476

(56) Entgegenhaltungen:
- EP-A- 0 165 561
- EP-A- 0 893 379
- DE-U- 8 327 161

## Beschreibung

### Anwendungsgebiet und Stand der Technik

Die Erfindung betrifft ein Verfahren und eine Vorrichtung zum Einbringen von flachen Substraten in einen Aufnahmebehälter.

In der Leiterplattenindustrie werden Substrate in Form von Leiterplatten odgl. nach einer Behandlung in Aufnahmebehälter gelegt, um sie aufzubewahren und/oder weiterzutransportieren. Da diese Substrate zum Teil sehr dünn und somit mechanisch sehr empfindlich sind, ist hier einerseits eine große Sorgfalt zu wahren. Andererseits kommt es darauf an, die Substrate nach ihrer Anlieferung auf Transportmitteln odgl. möglichst schnell in einen Aufnahmebehälter zu bringen. Hierzu werden Greifvorrichtungen verwendet, die die Substrate erfassen und in einen Aufnahmebehälter bringen. Zwischen die einzelnen Substrate werden Trennlagen gebracht. Auch diese Trennlagen werden mit einer Greifvorrichtung von einem entsprechenden Vorrat entnommen und in den Aufnahmebehälter bzw. auf ein Substrat gelegt.

Aus EP-A-0 893 379 ist eine Palettiervorrichtung bekannt, die Stapel mit Zwischenlagenpapieren auf Paletten ablegt. Dabei werden die Stapel mit Hilfe von Abstreifern von einem verfahrbaren Schiebeboden auf die Palette abgeschoben. Am Schiebeboden angebrachte Sauger ergreifen Lagenpapiere und halten diese durch unterdruck bis zum Abelegen auf dem Stapel test.

### Aufgabe und Lösung

Der Erfindung liegt die Aufgabe zugrunde, ein zuvor genanntes Verfahren sowie eine Vorrichtung zum Einbringen von flachen Substraten in einen Aufnahmebehälter zu schaffen, bei dem einerseits die Substrate sorgsam gehandhabt werden und andererseits Substrate sowie Trennlagen möglichst schnell abwechselnd in einen Aufnahmebehälter gelegt werden können.

Gelöst wird diese Aufgabe durch ein Verfahren mit den Merkmalen des Anspruchs 1 sowie eine Vorrichtung mit den Merkmalen des Anspruchs 11. Vorteilhafte sowie bevorzugte Ausgestaltungen der Erfindung sind Gegenstand der Unteransprüche und werden im folgenden näher erläutert. Der Wortlaut der Ansprüche wird durch ausdrückliche Bezugnahme zum Inhalt der Beschreibung gemacht.

Erfindungsgemäß weist ein Verfahren folgende Schritte auf:
a) Ein Substrat wird mit einer ersten Greifvorrichtung erfasst und von den Transportmitteln angehoben.
b) Die erste Greifvorrichtung und der Aufnahmebehälter werden relativ zueinander bewegt derart, dass sich der Aufnahmebehälter im Arbeitsbereich bzw. unterhalb der ersten Greifvorrichtung befindet.
c) Die erste Greifvorrichtung legt das Substrat in den Aufnahmebehälter ab, und zwar vorzugsweise in der Position nach Schritt b).
d) Eine zweite Greifvorrichtung erfasst eine Trennlage aus einem Vorrat von Trennlagen und hebt sie an.
e) Der Schritt b) wird umgekehrt derart, dass sich der Aufnahmebehälter von oben zugänglich bzw. für die vorschriftsmäßige Befüllung durch die zweite Greifvorrichtung unter derselben befindet.
f) Die Trennlage wird von der zweiten Greifvorrichtung in den Aufnahmebehälter auf das zuvor eingebrachte Substrat abgelegt.
g) Der Vorgang wird bei Schritt a) erneut gestartet und wiederholt.

Bei den vorstehend beschriebenen Verfahrensschritten handelt es sich um die Schritte, die auf alle Fälle ablaufen. Dabei ist es möglich, noch weitere Schritte dazwischen auszuführen, zusätzlich zu den oben aufgeführten. Insbesondere ist es möglich, dass einer der Schritte c) bis f) gleichzeitig mit mindestens einem anderen der Schritte c) bis f) erfolgt. Ebenso wird es als im Rahmen der hier beanspruchten Erfindung liegend angesehen, im zeitlichen Ablauf Schritt c) mit Schritt d) zu vertauschen oder Schritt d) mit e).

Die Substrate können mit Transportmitteln, beispielsweise einer Rollenbahn, angeliefert werden. Dabei liegen sie vorteilhaft flach. Mit der ersten Greifvorrichtung werden sie in den Aufnahmebehälter gebracht. Eine Bewegung der Greifvorrichtungen zwischen dem Erfassen von Substrat oder Trennlage und dem Einbringen in den Aufnahmebehälter erfolgt bevorzugt im wesentlichen vertikal.

Zur Vereinfachung des Aufbaus einer solchen Vorrichtung ist mindestens eine der beiden Greifvorrichtungen in horizontaler Richtung ortsfest angeordnet bzw. bewegt sich während der Arbeit nicht. Bei einer Ausgestaltungsform der Erfindung sind beide Greifvorrichtungen solchermaßen in horizontaler Richtung ortsfest und können nur im wesentlichen vertikal bewegt werden.

Der Aufnahmebehälter kann seitlich in horizontaler Richtung verschoben werden. Bevorzugt erfolgt dies entlang der Richtung zwischen den beiden Greifvorrichtungen. Besonders bevorzugt wird der Aufnahmebehälter genau zwischen den beiden Greifvorrichtungen bzw. zwischen Positionen unter den beiden Greifvorrichtungen bewegt. Dies kann so aussehen, dass der Aufnahmebehälter zwischen einer Position zum Einbringen des Substrats unterhalb der ersten Greifvorrichtung und einer Position zum Einbringen der Trennlage unter der zweiten Greifvorrichtung bewegt wird. Dabei kann es vorgesehen sein, dass die erste Greifvorrichtung oberhalb der Transportmittel für die Substrate angeordnet ist und so nicht horizontal bewegt werden muss.

Vorteilhaft sind die Greifvorrichtungen jeweils spezialisiert ausgebildet. Die erste Greifvorrichtung ist für die Substrate und die zweite Greifvorrichtung für die Trennlagen vorgesehen. Dies kann sich, wie nachfolgend deutlich wird, auf Ausbildung, Funktion und Position sowie Bewegbarkeit auswirken.

Des weiteren kann der Aufnahmebehälter oberhalb der Ebene der Transportmittel für die Substrate, insbesondere über die Transportmittel, bewegt werden. Dabei kann das Substrat bei nicht in dieser Position befindlichem Aufnahmebehälter mittels der ersten Greifvorrichtung von den Transportmitteln angehoben werden. Anschließend wird der Aufnahmebehälter unter die erste Greifvorrichtung positioniert bzw. bewegt und das Substrat in diesen abgelegt.

Der Aufnahmebehälter wird vorteilhaft oberhalb der Ebene des Trennlagenvorrats bewegt. Insbesondere kann er oberhalb des Vorrats derart bewegt werden, dass bei nicht in dieser Position befindlichem Aufnahmebehälter eine Trennlage mittels der zweiten Greifvorrichtung in einer vertikalen Bewegung von dem Vorrat angehoben und bei darunter positioniertem Aufnahmebehälter in diesen abgelegt wird.

Vorteilhaft werden abwechselnd eine Trennlage und ein Substrat in den Aufnahmebehälter eingebracht. Der Aufnahmebehälter kann zwischen einer Position unter der ersten Greifvorrichtung und einer Position unter der zweiten Greifvorrichtung hin- und herbewegt werden.

Bei einem weiteren Ausführungsbeispiel der Erfindung ist der Vorrat von Trennlagen ein bewegbarer Vorratsbehälter, wobei die Bewegbarkeit insbesondere in horizontaler Richtung gegeben ist. Der Vorratsbehälter kann zwischen einer Position zum Einbringen des Substrats über den Transportmitteln und einer Position zum Einbringen der Trennlage unter der zweiten Greifvorrichtung bewegt werden.

Es kann vorgesehen sein, dass eine der beiden Greifvorrichtungen in horizontaler Richtung verfahren wird zwischen einer Position über den Transportmitteln und einer Position über dem Aufnahmebehälter. Dabei kann der Aufnahmebehälter vorteilhaft zumindest während seiner Befüllung unbewegt bleiben. Der Vorratsbehälter dagegen wird zumindest in eine Position bewegt, in der die zweite Greifvorrichtung eine Trennlage aus dem Vorratsbehälter entnehmen kann. Hierbei ist vorteilhaft vorgesehen, dass die erste Greifvorrichtung in horizontaler Richtung seitlich bewegt wird. Dies kann insbesondere erfolgen zwischen einer Position zum Einbringen des Substrats über dem Transportmittel und einer Position unter der zweiten Greifvorrichtung, die in horizontaler Richtung ortsfest ist. Die zweite Greifvorrichtung kann eine Trennlage aus dem Vorratsbehälter erfassen, während die beiden Greifvorrichtungen, der Aufnahmebehälter und der Vorratsbehälter in vertikaler Richtung übereinander angeordnet sind.

Von besonderem Vorteil ist es, wenn der Vorratsbehälter auf ähnliche Weise wie die erste Greifvorrichtung bewegt wird, beispielsweise gleichzeitig und/oder entlang derselben Bahn. Besonders bevorzugt wird der Vorratsbehälter gleichzeitig mit der ersten Greifvorrichtung bewegt. Dabei können sie insbesondere mechanisch gekoppelt sein, wodurch lediglich ein einziger Antrieb benötigt wird.

Um auch mechanisch empfindliche und sehr dünne Substrate bewegen zu können, werden die Substrate, insbesondere auch die Trennlagen, flach bzw. horizontal liegend bewegt. Mit Vorteil können sie auch in dieser Stellung in den Aufnahmebehälter eingebracht werden und somit die ganze Zeit über in dieser Stellung bleiben.

Eine Vorrichtung zum Einbringen von dünnen Substraten in einen Aufnahmebehälter, die insbesondere gemäß einem vorstehend beschriebenen Verfahren arbeitet, kann vorsehen, dass sie zwischen die Substrate Trennlagen in den Aufnahmebehälter bringt. Es sind Transportmittel zur Anlieferung der Substrate und ein Vorrat von Trennlagen vorgesehen.

Transportmittel und Vorrat können beispielhaft wie vorstehend beschrieben ausgeführt sein.

Zum Erfassen, Bewegen und Ablegen der Substrate ist eine erste Greifvorrichtung vorgesehen. Zum Erfassen, Bewegen und Ablegen der Trennlagen ist eine zweite Greifvorrichtung vorgesehen. Beide Greifvorrichtungen sind zumindest für eine Bewegung in vertikaler Richtung ausgebildet. Mindestens eine der beiden Greifvorrichtungen ist dabei in horizontaler Richtung ortsfest angeordnet. Die andere Greifvorrichtung kann dann unter Umständen horizontal verfahren werden.

Der Aufnahmebehälter kann in horizontaler Richtung bewegbar ausgebildet sein, beispielsweise mit einem entsprechenden Antrieb. Die Bewegungsbahn verläuft zumindest zwischen einer Position unter der ersten Greifvorrichtung und einer Position unter der zweiten Greifvorrichtung.

Bei einem ersten Ausführungsbeispiel der Erfindung sind beide Greifvorrichtungen in horizontaler Richtung ortsfest. Dabei kann vorgesehen sein, dass die Bewegungsbahn des Aufnahmebehälters oberhalb der Transportmittel verläuft und vorzugsweise zumindest an einem Punkt über die Transportmittel reicht. Hier können die erste Greifvorrichtung, der Aufnahmebehälter in dieser Position und die Transportmittel im wesentlichen entlang einer vertikalen Linie übereinander angeordnet sein.

In weiterer Ausgestaltung kann der Aufnahmebehälter oberhalb des Vorrats der Trennlagen bewegbar sein. Seine Bewegungsbahn kann zumindest über den Vorrat reichen, wobei insbesondere in dieser Position des Aufnahmebehälters die zweite Greifvorrichtung, der Aufnahmebehälter und der Vorrat im wesentlichen entlang einer vertikalen Linie übereinander angeordnet sein können. Diese jeweils vertikale Anordnung übereinander ermöglicht es, durch rein vertikale Bewegungen der Greifvorrichtungen Substrate und Trennlagen in den Aufnahmebehälter zu bringen.

Bei einem zweiten Ausführungsbeispiel der Erfindung kann der Vorrat, insbesondere als Vorratsbehälter ausgebildet, in horizontaler Richtung bewegbar sein. Eine Bewegungsbahn kann zwischen einer Position zum Einbringen eines Substrats unterhalb der ersten Greifvorrichtung und einer Position zum Einbringen einer Trennlage unter der zweiten Greifvorrichtung verlaufen, vorzugsweise jeweils dort enden. Dabei kann eine Greifvorrichtung in horizontaler Richtung bewegbar sein zwischen einer Position über den in diesem Fall ortsfest angeordneten Transportmitteln und einer Position über dem Aufnahmebehälter. Hier ist vorteilhaft der Aufnahmebehälter während der Befüllung ortsfest und unbeweglich und braucht allgemein während der Befüllung nicht bewegt zu werden. Vorteilhaft ist hier die erste Greifvorrichtung für die Substrate bewegbar.

Zur Vereinfachung des Aufbaus kann der Vorratsbehälter mit der bewegbaren Greifvorrichtung gekoppelt sein zur gemeinsamen Bewegung. Es können Antriebsmittel vorgesehen sein, die den Vorratsbehälter und die Greifvorrichtung entlang einer mechanischen Führung, beispielsweise einer horizontal verlaufenden Führungsschiene, verfahren. Ebenso ist vorteilhaft eine entsprechende Steuerung für das Verfahren vorgesehen, die der Fachmann entsprechend seinem Fachwissen auszuführen weiß.

Des weiteren kann die zweite Greifvorrichtung in einer Ebene oberhalb der ersten Greifvorrichtung angeordnet sein, insbesondere mit Abstand dazu. Dadurch kann es ermöglicht werden, dass der Vorratsbehälter zwischen die beiden Greifvorrichtungen bewegt werden kann.

Die Greifvorrichtungen selber können derart ausgebildet sein, dass sie eine Grundhalterung aufweisen, welche unter Umständen horizontal verfahrbar sein kann. An dieser Grundhaltung kann ein senkrecht verfahrbarer Greifarm angeordnet sein. Der Greifarm kann nach unten weisende bzw. nach unten aktivierbare Greifmittel aufweisen, welche eine horizontale Ebene bilden bzw. in einer solchen liegen.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränkt die unter diesen gemachten Aussagen nicht in ihrer Allgemeingültigkeit.

### Kurzbeschreibung der Zeichnungen

Zwei Ausführungsbeispiele der Erfindung sind in den Zeichnungen dargestellt und werden im folgenden näher erläutert. In den Zeichnungen zeigen:
- Fig. 1 bis 8: ein erstes Ausführungsbeispiel der Erfindung, wobei die Greifvorrichtungen ortsfest sind und der Aufnahmebehälter bewegt wird; und
- Fig. 9 bis 16: ein zweites Ausführungsbeispiel der Erfindung, wobei die Greifvorrichtung für Leiterplatten zusammen mit einem Vorratsbehälter für Trennlagen bewegt wird.

### Detaillierte Beschreibung der Ausführungsbeispiele

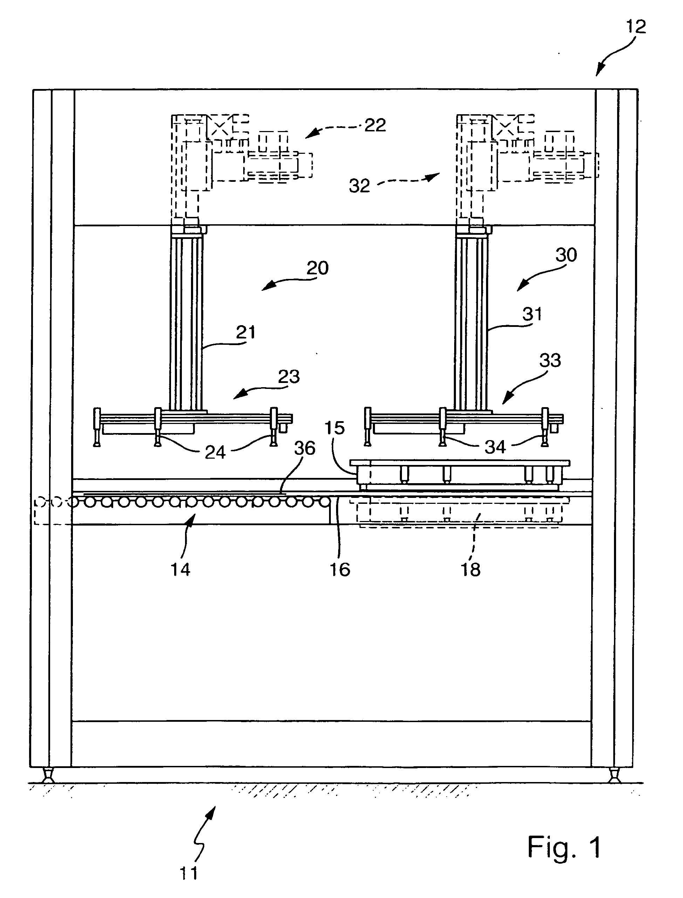

In Fig. 1 ist eine erfindungsgemäße Vorrichtung 11 dargestellt. Sie besteht aus einem Gehäuse 12, in dem die nachfolgend beschriebenen Einrichtungen angeordnet sind. Es ist eine Rollenbahn 14 vorhanden, auf der von links kommend Leiterplatten angeliefert werden, beispielsweise von anderen Prozess-Stationen kommend. Rechts davon und in einer darüber liegenden Ebene befindet sich ein Aufnahmebehälter 15, in den Leiterplatten abgelegt werden. Unter dem Aufnahmebehälter 15 und etwa nach oben auf gleicher Höhe wie die Rollenbahn 14 abschließend ist ein Vorratsbehälter 18 für Trennlagen angeordnet. Der Aufnahmebehälter 15 ist seitlich horizontal verfahrbar, wie aus den nachfolgenden Darstellungen deutlich wird. Der Vorratsbehälter 18 dagegen ist ortsfest.

Oberhalb der Rollenbahn 14 ist eine erste Greifvorrichtung 20 angeordnet. Sie besteht aus einem Greifarm 21, der oben an einer Grundhalterung 22 befestigt ist und von dieser vertikal verfahren werden kann. An dem Greifarm 21 ist unten ein Ausleger 23 angeordnet. Dieser trägt Greifmittel 24, welche nach unten hin eine Ebene bilden und mittels derer eine Leiterplatte erfasst werden kann. Dazu können die Greifmittel 24 beispielsweise als Saugeinrichtungen wie Saugnäpfe oder dergleichen ausgebildet sein.

Oberhalb des Vorratsbehälters 18 ist eine zweite Greifvorrichtung angeordnet, die der ersten Greifvorrichtung 20 ähnelt und im wesentlichen gleich aufgebaut sein kann. Sie besteht ebenfalls aus einem Greifarm 31, einer Grundhalterung 32, einem Ausleger 33 und daran angeordneten Greifmitteln 34, die nach unten hin eine Ebene bilden. Die Greifmittel 34 sind zum Erfassen der Trennlagen, beispielsweise Papier, ausgebildet.

In der Darstellung in Fig. 1, die der Ausgangsstellung des ersten beispielhaften Verfahrens entspricht, ist der Aufnahmebehälter 15 direkt über dem Vorratsbehälter 18 angeordnet und ebenfalls direkt darüber die zweite Greifvorrichtung 30.

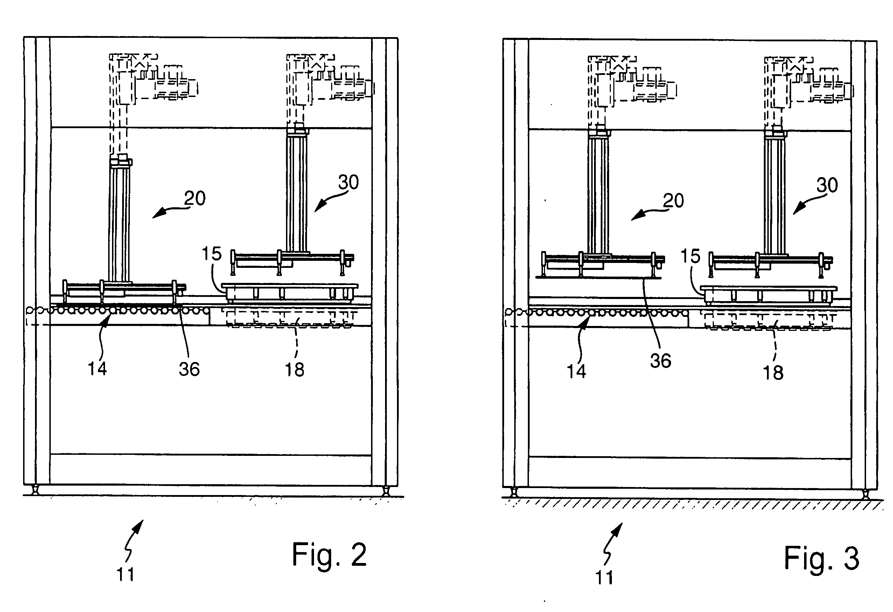

Den nächsten Schritt zeigt Fig. 2. Auf der Rollenbahn 14 ist eine Leiterplatte 36 angeliefert worden und kommt, entsprechend gesteuert, genau unter der ersten Greifvorrichtung 20 zu stehen. Diese ist bereits soweit abgesenkt, dass die Greifmittel 24 die Leiterplatte 36 erfassen.

Der eingangs genannte Verfahrensschritt a) ist in Fig. 2 und in Fig. 3 dargestellt. In Fig. 3 hat die erste Greifvorrichtung 20 die gemäß Fig. 2 erfasste Leiterplatte 36 angehoben. Das Anheben erfolgt so weit, dass die Leiterplatte 36 mit Abstand oberhalb des Aufnahmebehälters 15 hängt. Dabei kann die erste Greifvorrichtung 20 im wesentlichen soweit nach oben gezogen sein wie in Fig. 1.

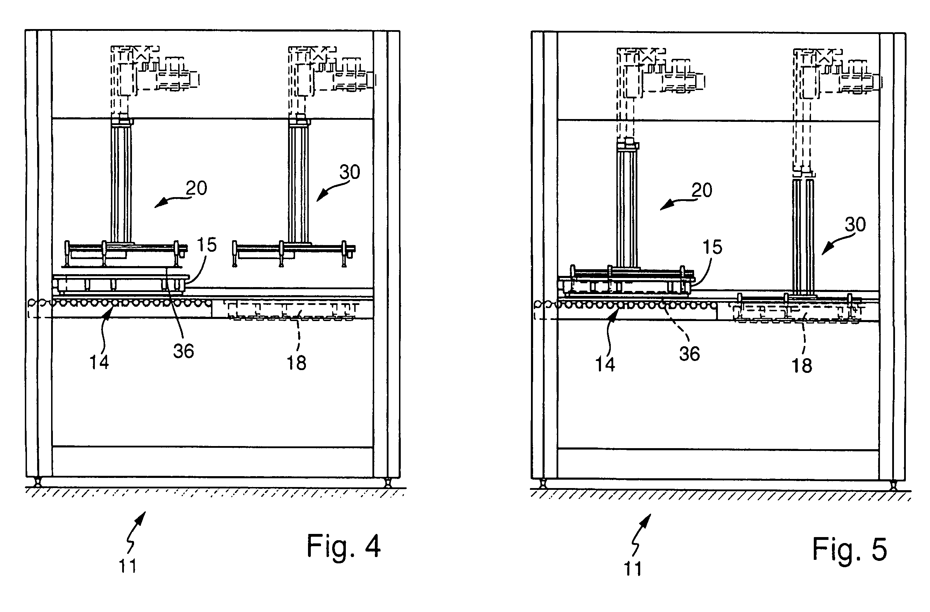

In Fig. 4 wird der Verfahrensschritt b) dargestellt, indem der Aufnahmebehälter 15 nach links unter die erste Greifvorrichtung 20 bzw. unter die Leiterplatte 36 verfahren ist. Dieses Verfahren erfolgt auf einer Fahrbahn 16 und kann beispielsweise mittels Rollen und Schienen oder dergleichen erfolgen.

In Fig. 5 ist zum einen der Verfahrensschritt c) dargestellt. Hier ist die erste Greifvorrichtung 20 nach unten verfahren und legt so die Leiterplatte 36 in den Aufnahmebehälter 15 ab. Gleichzeitig oder auch zeitlich versetzt führt die zweite Greifvorrichtung 30 zumindest den ersten Teil des Verfahrensschritts d) aus. Dazu ist sie nach unten in den Vorratsbehälter 18 verfahren. Die Greifmittel 34 ergreifen dabei eine Trennlage 38 in dem Vorratsbehälter 18. Bevorzugt verläuft das Absenken der Greifvorrichtungen 20 und 30 gleichzeitig. Zum einen stören sich die beiden Bewegungen nicht. Zum anderen kann dadurch Zeit gespart werden.

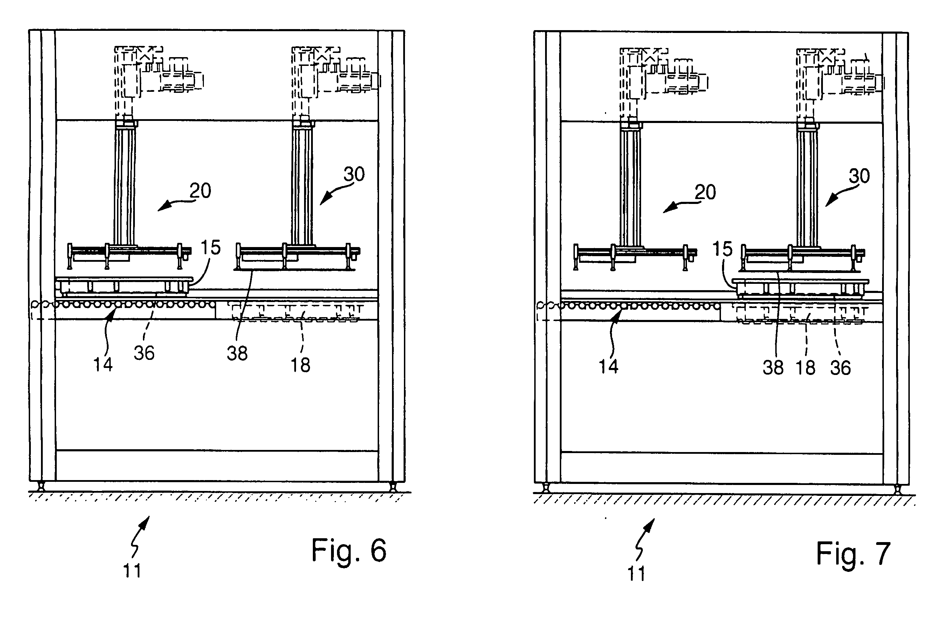

In Fig. 6 sind die Greifvorrichtungen 20 und 30 wieder nach oben gefahren. Dabei hebt die zweite Greifvorrichtung 30 die Trennlage 38 an und vollzieht somit den zweiten Teil des Schrittes d). Wie zuvor beschrieben, erfolgt das Anheben nach oben bevorzugt gleichzeitig, um Zeit zu sparen. Auf alle Fälle wird die zweite Greifvorrichtung soweit nach oben gezogen, dass die Trennlage 38 oberhalb des Aufnahmebehälters 15 schwebt.

In Fig. 7 ist zu sehen, wie der Aufnahmebehälter 15 von links unterhalb der ersten Greifvorrichtung 20 nach rechts unter die zweite Greifvorrichtung 30 verfahren worden ist. Damit erfolgt die Umkehrung des Schrittes b) gemäß dem Schritt e). Der Aufnahmebehälter 15 befindet sich genau unterhalb der Trennlage 38 bzw. genau in der Position, die zum direkten vertikalen Absenken der Trennlage 38 in den Aufnahmebehälter 15 vorgesehen ist.

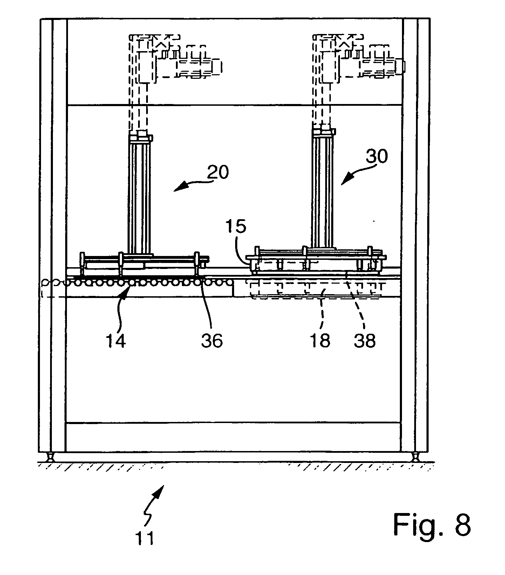

In Fig. 8 ist zu sehen, wie die zweite Greifvorrichtung 30 nach unten gefahren ist und die Trennlage 38 in den Aufnahmebehälter 15 und auf die Leiterplatte 36 abgelegt hat. Dies entspricht dem Schritt f).

Gleichzeitig oder mittlerweile ist von links eine neue Leiterplatte 36 auf der Rollenbahn 14 angeliefert worden. Die erste Greifvorrichtung 20 ist abgesenkt, so dass die Greifmittel 24 die Leiterplatte 36 ergreifen. Dies entspricht bis auf die abgesenkte zweite Greifvorrichtung 30 der Darstellung in Fig. 2. So ist erkennbar, wie das Verfahren erneut startet.

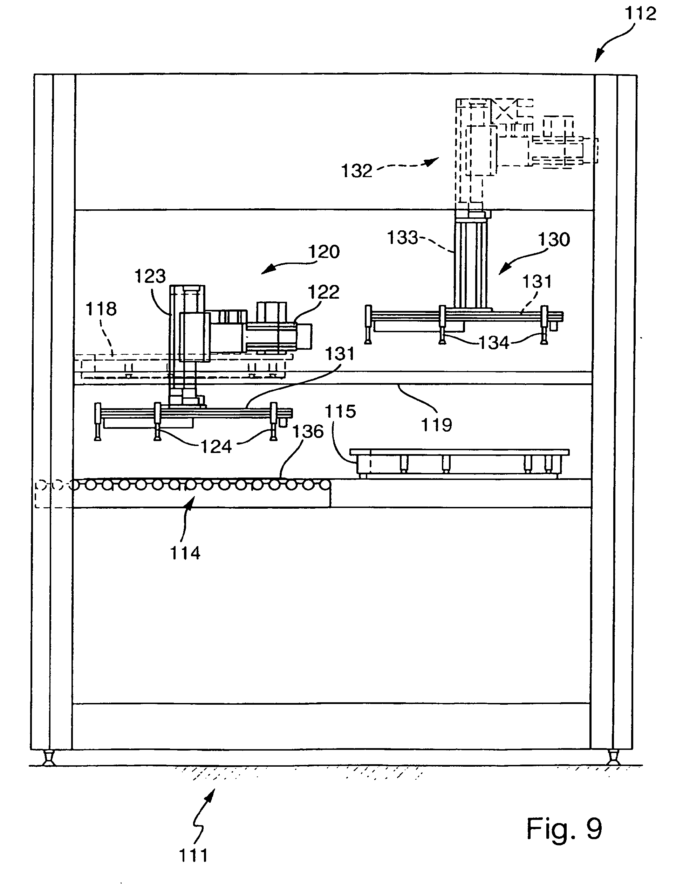

Ein zweites Ausführungsbeispiel der Erfindung ist in Fig. 9 dargestellt. Die Vorrichtung 111 weist dabei ein Gehäuse 112 auf und ähnelt insofern derjenigen aus Fig. 1.

Im linken Bereich ist eine Rollenbahn 114 vorgesehen, die sich nach links auch weiter erstrecken kann und auf welcher Leiterplatten angeliefert werden. Rechts neben der Rollenbahn 114 und darüber liegend angeordnet befindet sich ein Aufnahmebehälter 115. In diesen Aufnahmebehälter 115 werden die Leiterplatten mit Trennlagen dazwischen eingestapelt.

Oberhalb der Rollenbahn 114 ist ein Vorratsbehälter 118 angeordnet. Er ist auf einer horizontal verlaufenden Fahrbahn 119 verfahrbar. Die Fahrbahn 119 erstreckt sich so weit, dass der Vorratsbehälter 118 zwischen einer Position über der Rollenbahn 114 und einer Position über dem Aufnahmebehälter 115 verfahrbar ist.

Ebenfalls oberhalb der Rollenbahn 114 ist eine erste Greifvorrichtung 120 angeordnet. Sie besteht aus einem Greifarm 121, der an einer Grundhalterung 122 vertikal verschiebbar angeordnet ist. Unten trägt der Greifarm 121 einen Ausleger 123 mit nach unten gerichteten Greifmitteln 124. Dabei bilden die Greifmittel 124, ähnlich wie bei den zuvor beschriebenen Figuren 1 bis 8, eine Ebene.

Die Grundhalterung 122 ist in horizontaler Richtung verfahrbar ausgebildet. Bevorzugt ist sie dabei an der Fahrbahn 119 gelagert und entlang dieser verfahrbar. Besonders bevorzugt ist sie gemeinsam mit dem Vorratsbehälter 118 verfahrbar, wobei sie gekoppelt sein und einen gemeinsamen Antrieb aufweisen können.

Der wesentliche Teil der Grundhalterung 122 befindet sich oberhalb des Vorratsbehälters 118. Der Ausleger 123 samt Greifmitteln 124 befindet sich unterhalb des Vorratsbehälters. Oberhalb des Aufnahmebehälters 115 ist in Entsprechung zu Fig. 1 eine zweite Greifvorrichtung 130 angeordnet. Sie besteht aus einer Grundhalterung 132, einem Greifarm 131, einem Ausleger 133 und Greifmitteln 134. Die zweite Greifvorrichtung 130 ist ortsfest angeordnet und kann nur vertikal agieren.

In der in Fig. 9 dargestellten Position befindet sich der Ausleger 133 mit den Greifmitteln 134 ein Stück oberhalb des oberen Randes des Vorratsbehälters 118. Aus diesem entnimmt die zweite Greifvorrichtung 130 Trennlagen, wie in den nachfolgenden Figuren zu sehen ist.

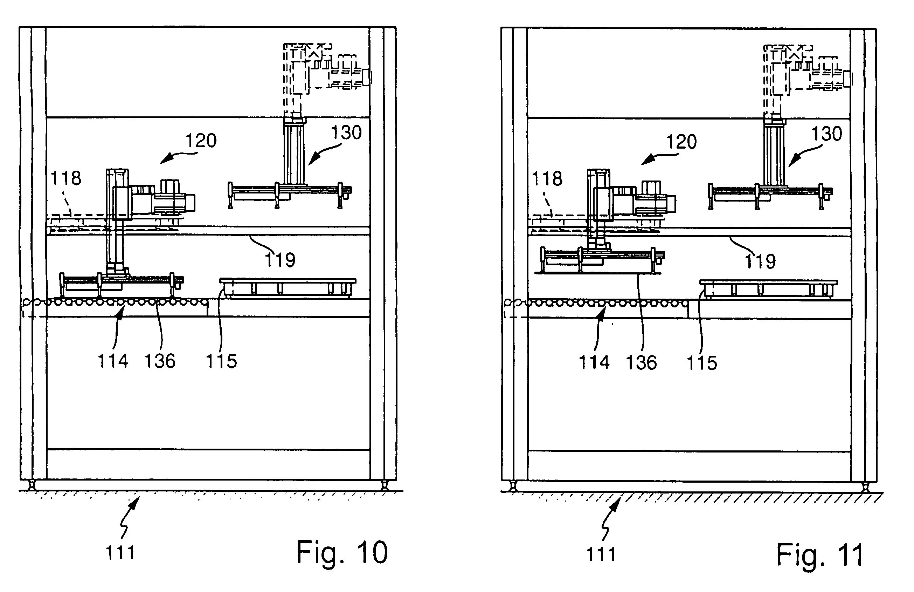

In Fig. 10 ist zu erkennen, wie eine Leiterplatte 136 auf der Rollenbahn 114 angeliefert worden ist. Die erste Greifvorrichtung 120 hat sich abgesenkt, damit die Greifmittel 124 die Leiterplatte 136 erfassen. Dies stellt entsprechend Fig. 2 den ersten Teil des Schrittes a) dar.

In Fig. 11 ist der zweite Teil des Schrittes a) des erfindungsgemäßen Verfahrens dargestellt. Hier ist nämlich die Leiterplatte 136 von der ersten Greifvorrichtung 120 soweit angehoben worden, dass sie sich oberhalb des oberen Randes des Aufnahmebehälters 115 befindet.

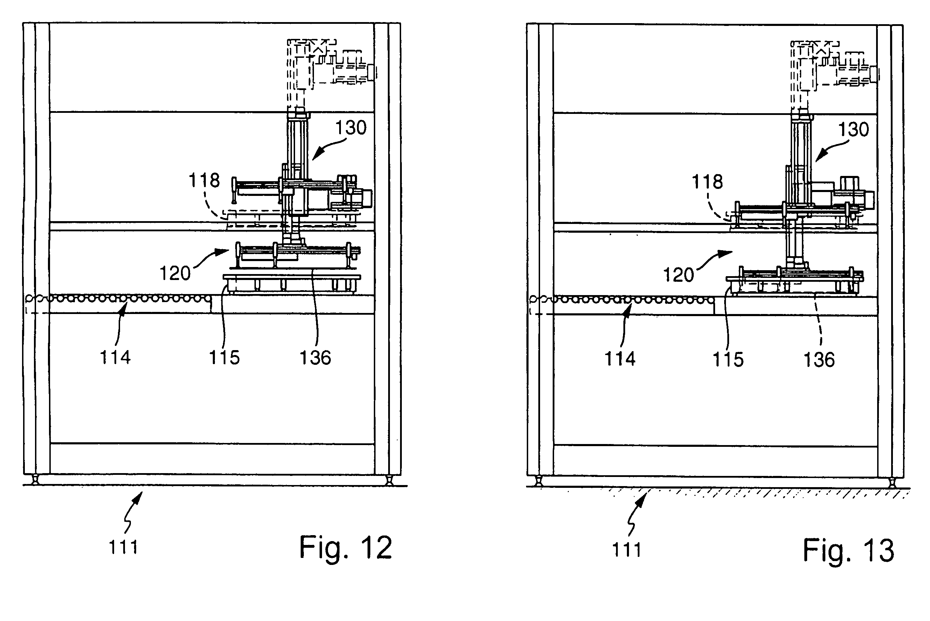

In Fig. 12 ist der Schritt b) dargestellt, in dem sich nämlich die erste Greifvorrichtung 120 zusammen mit dem Vorratsbehälter 118 nach rechts bewegt hat. Dabei befindet sie sich in einer Position oberhalb des Aufnahmebehälters 115. Somit ist hier bei der Relativbewegung zwischen erster Greifvorrichtung und Aufnahmebehälter die Greifvorrichtung bewegt worden. Dabei ist zu erkennen, wie gleichzeitig der Vorratsbehälter 118 unter der zweiten Greifvorrichtung 130 zum Stand gekommen ist.

In Fig. 13 ist der Schritt c) dargestellt, in dem die erste Greifvorrichtung 120 die Leiterplatte 136 in den Aufnahmebehälter 115 abgelegt hat. Gleichzeitig hat sich die zweite Greifvorrichtung 130 in den Vorratsbehälter 118 abgesenkt und eine Trennlage 138 erfasst. Dies entspricht dem ersten Teil des Schrittes d). Wie zuvor beschrieben, kann das Absenken der Greifvorrichtungen vorteilhaft zur Zeitersparnis gleichzeitig erfolgen, ist jedoch nicht zwangsläufig.

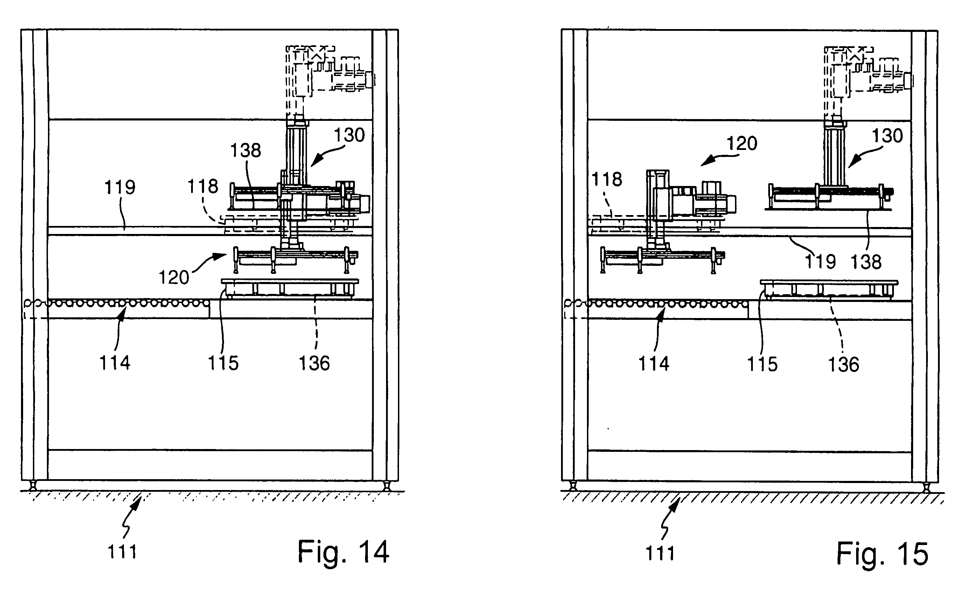

In Fig. 14 ist der zweite Teil des Schrittes d), nämlich das Anheben einer Trennlage 138 aus dem Vorratsbehälter 118 durch die zweite Greifvorrichtung 130, dargestellt. Ebenso ist hier, beispielsweise wiederum gleichzeitig, die erste Greifvorrichtung 120 nach oben aus dem Aufnahmebehälter 115 heraus verfahren.

In Fig. 15 wiederum ist der Schritt e) dargestellt, in dem die erste Greifvorrichtung 120 und der Vorratsbehälter 118 wieder nach links in die Position gemäß Fig. 9 verfahren worden sind. Nun ist der Aufnahmebehälter 115 zugänglich für das Ablegen der Trennlage 138.

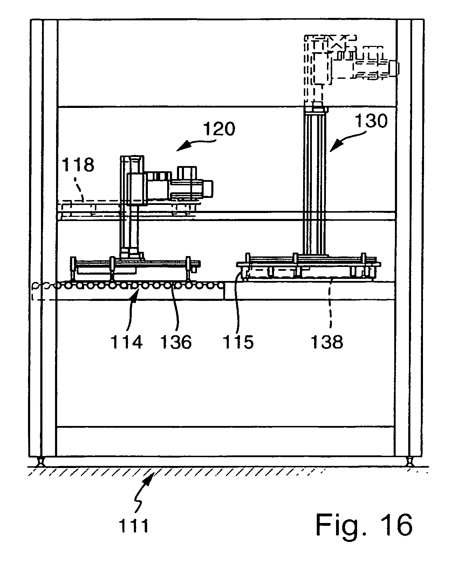

Dieses Ablegen gemäß dem Verfahrensschritt f) ist in Fig. 16 dargestellt. Dazu ist die zweite Greifvorrichtung 130 nach unten in den Vorratsbehälter 118 gefahren. Ebenfalls gleichzeitig ist auf der Rollenbahn 114 von links eine neue Leiterplatte 136 angeliefert worden. Hier hat sich bereits wieder die erste Greifvorrichtung 120 abgesenkt und diese Leiterplatte 136 erfasst. Nun kann das Verfahren entsprechend der Fig. 10 wieder von neuem beginnen.

Aus den Figuren sowie der vorstehenden Beschreibung wird deutlich, dass bei dem ersten Ausführungsbeispiel der Erfindung lediglich der Aufnahmebehälter 15 hin- und hergefahren wird unter den beiden Greifvorrichtungen 20 und 30. Bei dem zweiten Ausführungsbeispiel werden sowohl der Vorratsbehälter 118 als auch die erste Greifvorrichtung 120 verfahren. Dies bedeutet zwar einerseits einen erhöhten mechanischen und steuerungstechnischen Aufwand, insbesondere hinsichtlich der ersten verfahrbaren Greifvorrichtung 120. Andererseits wird hierbei jeweils nur eine Leiterplatte seitlich verfahren. Bei dem ersten Ausführungsbeispiel wird jeweils der gesamte, unter Umständen beinahe volle, Aufnahmebehälter verfahren.

## Patentansprüche

1. Verfahren zum Einbringen von flachen Substraten, insbesondere Leiterplatten (36, 136), in einen Aufnahmebehälter (15, 115), wobei das Verfahren folgende Schritte aufweist:
a) Erfassen und Anheben eines Substrats (36, 136) mit einer ersten Greifvorrichtung (20, 120);
b) Bewegen der ersten Greifvorrichtung (20, 120) und des Aufnahmebehälters (15, 115) relativ zueinander derart, dass sich der Aufnahmebehälter (15, 115) unterhalb der ersten Greifvorrichtung (20, 120) befindet;
c) die erste Greifvorrichtung (20, 120) legt das Substrat (36, 136) in den Aufnahmebehälter (15, 115) ab;
d) Erfassen und Anheben einer Trennlage (38, 138) aus einem Vorrat (18, 118) von Trennlagen mit einer zweiten Greifvorrichtung (30, 130);
e) Umkehrung von Schritt b) derart, dass sich der Aufnahmebehälter (15, 115) von oben zugänglich unter der zweiten Greifvorrichtung (30, 130) befindet;
f) die Trennlage (38) wird in dem Aufnahmebehälter (15, 115) auf das zuvor eingebrachte Substrat (36, 136) abgelegt;
g) Starten des Vorgangs bei a).

2. Verfahren nach Anspruch 1, **dadurch gekennzeichnet, dass** die Substrate (36, 136) mit Transportmitteln (14, 114) angeliefert werden und mittels der ersten Greifvorrichtung (20, 120) von den Transportmitteln (14, 114) weg in den Aufnahmebehälter (15, 115) gebracht werden, wobei vorzugsweise die Bewegung der ersten Greifvorrichtung (20, 120) zwischen dem Erfassen von Leiterplatte (36, 136) und Trennlage (38, 138) und dem Einbringen in den Aufnahmebehälter (15, 115) im wesentlichen vertikal erfolgt.

3. Verfahren nach Anspruch 1 oder 2, **dadurch gekennzeichnet, dass** mindestens eine der beiden Greifvorrichtungen (20, 120, 30, 130) in horizontaler Richtung ortsfest ist, insbesondere beide Greifvorrichtungen.

4. Verfahren nach einem der vorhergehenden Ansprüche, **dadurch gekennzeichnet, dass** der Aufnahmebehälter (15, 115) zwischen einer Position zum Einbringen des Substrats (36, 136) unterhalb der ersten Greifvorrichtung (20, 120) und einer Position zum Einbringen der Trennlage (38, 138) unter der zweiten Greifvorrichtung (30, 130) seitlich in horizontaler Richtung hin- und herbewegt wird, wobei insbesondere die erste Greifvorrichtung (20, 120) oberhalb der Transportmittel (14, 114) für die Substrate angeordnet ist.

5. Verfahren nach einem der vorhergehenden Ansprüche, **dadurch gekennzeichnet, dass** der Aufnahmebehälter (15) oberhalb der Ebene der Transportmittel (14) für die Substrate bewegt wird, vorzugsweise über die Transportmittel derart, dass das Substrat (36) bei nicht vorhandenem Aufnahmebehälter (15) mittels der ersten Greifvorrichtung (20) von den Transportmitteln abgehoben wird, und bei unter der ersten Greifvorrichtung positioniertem Aufnahmebehälter in diesen abgelegt wird.

6. Verfahren nach einem der vorhergehenden Ansprüche, **dadurch gekennzeichnet, dass** der Aufnahmebehälter (15) oberhalb der Ebene des Vorrats (18) von Trennlagen (38) bewegt wird, vorzugsweise über den Vorrat (18) von Trennlagen (38) derart, dass eine Trennlage mittels der zweiten Greifvorrichtung (30) von dem Vorrat angehoben wird bei entferntem Aufnahmebehälter und bei unter der zweiten Greifvorrichtung positioniertem Aufnahmebehälter (15) in diesen abgelegt wird.

7. Verfahren nach einem der Ansprüche 1 - 3, **dadurch gekennzeichnet, dass** der Vorrat von Trennlagen (38, 138) ein Vorratsbehälter (18, 118) ist und bewegbar ist, insbesondere in horizontaler Richtung bewegbar ist, wobei er vorzugsweise zwischen einer Position zum Einbringen des Substrats (136) über den Transportmitteln (114) für die Substrate und einer Position zum Einbringen der Trennlage (138) unter der zweiten Greifvorrichtung (130) bewegt wird.

8. Verfahren nach Anspruch 7, **dadurch gekennzeichnet, dass** eine der beiden Greifvorrichtungen (120, 130) in horizontaler Richtung verfahren wird zwischen einer Position über den Transportmitteln (114) und einer Position über dem Aufnahmebehälter (115), wobei vorzugsweise der Aufnahmebehälter (115) zumindest während seiner Befüllung unbewegt bleibt und der Vorratsbehälter (118) bewegt wird zumindest in eine Position, in der die zweite Greifvorrichtung (130) eine Trennlage (138) aus dem Vorratsbehälter (118) entnehmen kann.

9. Verfahren nach Anspruch 8, **dadurch gekennzeichnet, dass** die erste Greifvorrichtung (120) in horizontaler Richtung seitlich bewegt wird, wobei sie vorzugsweise zwischen einer Position zum Einbringen des Substrats (136) über den Transportmitteln (114) für die Substrate und einer Position unter der zweiten Greifvorrichtung (130) bewegt wird.

10. Verfahren nach einem der Ansprüche 7 bis 9, **dadurch gekennzeichnet, dass** die zweite Greifvorrichtung (130) oberhalb der ersten Greifvorrichtung (120) angeordnet ist und eine Trennlage (138) aus dem Vorratsbehälter (118) erfasst, während beide Greifvorrichtungen und Aufnahmebehälter (115) und Vorratsbehälter entlang einer senkrechten Linie angeordnet sind.

11. Vorrichtung zum Einbringen von flachen Substraten in einen Aufnahmebehälter mit einem Verfahren gemäß einem der vorhergehenden Ansprüche, wobei zwischen die Substrate (36, 136) Trennlagen (38, 138) in den Aufnahmebehälter (15, 115) gebracht werden, mit
- Transportmitteln (14, 114) zur Anlieferung von Substraten (36, 136) und mit einem Vorrat (18, 118) von Trennlagen,
- einer ersten Greifvorrichtung (20, 120) für das Erfassen, Bewegen und Ablegen der Substrate und
- einer zweiten Greifvorrichtung (30, 130) für das Erfassen, Bewegen und Ablegen der Trennlagen,
wobei die Greifvorrichtungen zumindest für eine Bewegung in vertikaler Richtung ausgebildet sind, und wobei mindestens eine der beiden Greifvorrichtungen in horizontaler Richtung ortsfest angeordnet ist.

12. Vorrichtung nach Anspruch 11, **dadurch gekennzeichnet, dass** der Aufnahmebehälter (15, 115) in horizontaler Richtung bewegbar ausgebildet ist, wobei er insbesondere zumindest zwischen einer Position unter der ersten Greifvorrichtung (20, 120) und einer Position unter der zweiten Greifvorrichtung (30, 130) bewegbar ist.

13. Vorrichtung nach Anspruch 11 oder 12, **dadurch gekennzeichnet, dass** beide Greifvorrichtungen (20, 120, 30, 130) in horizontaler Richtung ortsfest sind und in vertikaler Richtung bewegbar sind.

14. Vorrichtung nach einem der Ansprüche 11 bis 13, **dadurch gekennzeichnet, dass** eine Bewegungsbahn des Aufnahmebehälters (15, 115) oberhalb der Transportmittel (14, 114) verläuft, vorzugsweise zumindest an einem Punkt über die Transportmittel reicht, wobei insbesondere die erste Greifvorrichtung (20, 120), der Aufnahmebehälter (15, 115) in dieser Position und die Transportmittel (14, 114) im wesentlichen entlang einer vertikalen Linie übereinander angeordnet sind.

15. Vorrichtung nach einem der Ansprüche 11 bis 14, **dadurch gekennzeichnet, dass** der Aufnahmebehälter (15) oberhalb des Vorrats (18) der Trennlagen (38) bewegbar ist, wobei vorzugsweise die Bewegungsbahn des Aufnahmebehälters zumindest Ober den Vorrat der Trennlagen reicht und insbesondere die zweite Greifvorrichtung (30), der Aufnahmebehälter (15) in dieser Position und der Vorrat (18) im wesentlichen entlang einer vertikalen Linie übereinander angeordnet sind.

16. Vorrichtung nach Anspruch 15, **dadurch gekennzeichnet, dass** eine Greifvorrichtung (120, 130) in horizontaler Richtung bewegbar ist zwischen einer Position über den ortsfest angeordneten Transportmitteln (114) und einer Position Ober einem Aufnahmebehälter (115), wobei vorzugsweise der Aufnahmebehälter (115) während der Befüllung ortsfest und unbeweglich ist.

17. Vorrichtung nach Anspruch 16, **dadurch gekennzeichnet, dass** der Vorrat ein Vorratsbehälter (118) ist und mechanisch mit der ersten Greifvorrichtung (120) gekoppelt ist zur gemeinsamen Bewegung, wobei Antriebsmittel vorgesehen sind, welche den Vorratsbehälter (118) und die erste Greifvorrichtung (120) entlang einer mechanischen Führung (119) verfahren.

18. Vorrichtung nach Anspruch 16 oder 17, **dadurch gekennzeichnet, dass** die zweite Greifvorrichtung (130) in einer Ebene oberhalb der ersten Greifvorrichtung (120) angeordnet ist derart, dass der Vorratsbehälter (118) zwischen die beiden Greifvorrichtungen bewegbar ist.

19. Vorrichtung nach einem der Ansprüche 11 bis 18, **dadurch gekennzeichnet, dass** die Greifvorrichtungen (20, 120, 30, 130) eine Grundhalterung (22, 122, 32, 132) aufweisen, die insbesondere horizontal seitlich verfahrbar ist, wobei an der Grundhalterung ein senkrecht verfahrbarer Greifarm (21, 121, 31, 131) mit nach unten weisenden Greifmitteln (24, 124, 34, 134) angeordnet ist und die Greifmittel eine horizontale Ebene bilden.

## Claims

1. A method for the introduction of planar substrates, in particular circuit boards (36, 136), into a receiving container (15, 115), whereby the method has the following steps: a) gripping and lifting a substrate (36, 136) with a first gripping device (20, 120);
b) moving the first gripping device (20, 120) and the receiving container (15, 115) relative to each other, such that the receiving container (15, 115) is located below the first gripping device (20, 120);
c) the first gripping device (20, 120) places the substrate (36, 136) into the receiving container (15, 115);
d) gripping and lifting a partition layer (38, 138) from a store (18, 118) of partition layers with a second gripping device (30, 130);
e) reversion of step b) such that the receiving container (15, 115) is accessible from above and is below the second gripping device (30, 130);
f) the partition layer (38) is placed in the receiving container (15, 115) onto the previously supplied substrate (36, 136);
g) restarting the process at a).

2. The method according to claim 1, **characterized in that** the substrates (36, 136) are delivered by transporting means (14, 114) and are moved by means of the first gripping device (20, 120) away from the transporting means (14, 114) into the receiving container (15, 115), whereby preferably the movement of the first gripping device (20, 120) between the gripping of circuit board (36, 136) and partition layer (38, 138) and the movement into the receiving container (15, 115) occurs essentially vertically.

3. The method according to claim 1 or 2, **characterized in that** at least one of the two gripping devices (20, 120, 30, 130) is stationary in a horizontal direction, in particular both gripping devices.

4. The method according to any of the preceding claims, **characterized in that** the receiving container (15, 115) is moved back and forth laterally in a horizontal direction between a position for supplying the substrate (36, 136) below the first gripping device (20, 120) and a position for supplying the partition layer (38, 138) below the second gripping device (30, 130), whereby in particular the first gripping device (20, 120) is arranged above the transporting means (14, 114) for the substrates.

5. The method according to any of the preceding claims, **characterized in that** the receiving container (15) is moved above the plane of the transporting means (14) for the substrates, preferably by the transporting means such that the substrate (36), when no receiving container (15) is present, is lifted off from the transporting means by means of the first gripping device (20), and is placed into the receiving container positioned under the first gripping device.

6. The method according to any of the preceding claims, **characterized in that** the receiving container (15) is moved above the plane of the store (18) of partition layers (38), preferably across the store (18) of partition layers (38) such that a partition layer is lifted off from the store by means of the second gripping device (30) with removed receiving container and is placed into the receiving container (15) when it is positioned below the second gripping device.

7. The method according to any of claims 1-3, **characterized in that** the store of partition layers (38, 138) is a storage container (18, 118) and is movable, in particular, in a horizontal direction, whereby the storage container is moved preferably between a position for supplying the substrate (136) by the transporting means (114) for the substrates, and a position for supplying the partition layer (138) below the second gripping device (130).

8. The method according to claim 7, **characterized in that** one of the two gripping devices (120, 130) is moved in a horizontal direction between a position above the transporting means (114) and a position above the receiving container (115), whereby preferably the receiving container (115) is not moved at least while it is being filled, and the storage container (118) is moved at least into a position in which the second gripping device (130) can remove a partition layer (138) from the storage container (118).

9. The method according to claim 8, **characterized in that** the first gripping device (120) is laterally moved in a horizontal direction, whereby it is preferably moved between a position for supplying the substrate (136) above the transporting means (114) for the substrates and a position below the second gripping device (130).

10. The method according to any of claims 7 to 9, **characterized in that** the second gripping device (130) is arranged above the first gripping device (120) and grips a partition layer (138) from the storage container (118), while both gripping devices and receiving container (115) and storage container are arranged along a vertical line.

11. A device for supplying planar substrates into a receiving container, by a method according to any of the preceding claims, whereby partition layers (38, 138) are moved between the substrates (36, 136) into the receiving container (15, 115), comprising
- transporting means (14, 114) for the delivery of substrates (36, 136) and comprising a store (18, 118) of partition layers,
- a first gripping device (20, 120) for gripping, moving and placing the substrates, and
- a second gripping device (30, 130) for gripping, moving and placing the partition layers,
whereby the gripping devices are designed to move at least in a vertical direction, and whereby at least one of the two gripping devices is stationarily arranged in a horizontal direction.

12. The device according to claim 11, **characterized in that** the receiving container (15, 16) can be moved in a horizontal direction, and in particular, can be moved at least between one position below the first gripping device (20, 120) and a position below the second gripping device (30, 130).

13. The device according to claim 11 or 12, **characterized in that** both gripping devices (20, 120, 30, 130) are stationary in a horizontal direction and can be moved in a vertical direction.

14. The device according to any of claims 11 to 13, **characterized in that** a path of movement of the receiving container (15, 115) extends above the transporting means (14, 114), preferably reaches at least one point above the transporting means, whereby in particular the first gripping device (20, 120), the receiving container (15, 115) in this position, and the transporting means (14, 114) are arranged essentially along a vertical line one above the other.

15. The device according to any of claims 11 to 14, **characterized in that** the receiving container (15) can be moved above the store (18) of partition layers (38), whereby preferably the path of movement of the receiving container reaches at least above the store of partition layers, and in particular the second gripping device (30), the receiving container (15) in this position, and the store (18) are arranged essentially along a vertical line one above the other.

16. The device according to claim 15, **characterized in that** one gripping device (120, 130) can be moved in a horizontal direction between a position above the stationarily arranged transporting means (114) and a position above a receiving container (115), whereby preferably the receiving container (115) is stationary and nonmovable during filling.

17. The device according to claim 16, **characterized in that** the store is a storage container (118) and is mechanically coupled to the first gripping device (120) for joint movement, whereby driving means are provided which move the storage container (118) and the first gripping device (120) along a mechanical guideway (119).

18. The device according to claim 16 or 17, **characterized in that** the second gripping device (130) is arranged in a plane above the first gripping device (120) so that the storage container (118) can be moved between the two gripping devices.

19. The device according to any of claims 11 to 18, **characterized in that** the gripping devices (20, 120, 30, 130) have a base mounting (22, 122, 32, 132), which can be driven in particular horizontally laterally, whereby a vertically movable gripping arm (21, 121, 31, 131) with downwardly pointing gripping means (24, 124, 34, 134) is arranged on the base mounting, and the gripping means form a horizontal plane.

## Revendications

1. Procédé d'insertion de substrats plats, en particulier de circuits imprimés (36, 136) dans un réceptacle (15, 115), sachant que le procédé présente les étapes suivantes :
a) saisie et levée d'un substrat (36, 136) à l'aide d'un premier dispositif de préhension (20, 120)
b) déplacement du premier dispositif de préhension (20, 120) et du réceptacle (15, 115) coordonné l'un par rapport à l'autre de telle manière que le réceptacle (15, 115) se trouve au-dessous du premier dispositif de préhension (20, 120) ;
c) le premier dispositif de préhension (20, 120) dépose le substrat (36, 136) dans le réceptacle (15, 115) ;
d) saisie et levée d'une couche de séparation (38, 138) dans un stock (18, 118) de couches de séparation à l'aide d'un second dispositif de préhension (30, 130) ;
e) étape b) dans l'ordre inverse de telle manière que le réceptacle (15, 115) accessible par le haut se trouve sous le second dispositif de préhension (30, 130) ;
f) la couche de séparation (38) est déposée dans le réceptacle (15, 115) sur le substrat (36, 136) auparavant déposé ;
g) reprise du procédé à a).

2. Procédé selon la revendication 1, **caractérisé en ce que** les substrats (36, 136) sont amenés à l'aide d'éléments de transport (14, 114) et déposés dans le réceptacle (15, 115) à partir des éléments de transport (14, 114) à l'aide du premier dispositif de préhension (20, 120), sachant que le mouvement du premier dispositif de préhension (20, 120) entre la saisie du circuit imprimé (36, 136) et de la couche de séparation (38, 138) et l'insertion dans le réceptacle (15, 115) a lieu essentiellement à la verticale.

3. Procédé selon la revendication 1 ou 2, **caractérisé en ce qu'**au moins un des deux dispositifs de préhension (20, 120, 30, 130) est fixé dans le sens horizontal, en particulier les deux dispositifs de préhension.

4. Procédé selon une des revendications précédentes, **caractérisé en ce que** le réceptacle (15, 115) est déplacé latéralement à l'horizontale dans un sens et dans l'autre entre une position permettant l'insertion du substrat (36, 136) sous le premier dispositif de préhension (20, 120) et une position permettant l'insertion de la couche de séparation (38, 138) sous le second dispositif de préhension (30, 130), sachant en particulier que le premier dispositif de préhension (20, 120) est disposé au-dessus des éléments de transport (14, 114) pour les substrats.

5. Procédé selon une des revendications précédentes, **caractérisé en ce que** le réceptacle (15) est déplacé au-dessus du niveau des éléments de transport (14) pour les substrats, de préférence en surplomb des éléments de transport de telle manière que le substrat (36) est soulevé des éléments de transport à l'aide du premier dispositif de préhension (20) lorsque le réceptacle (15) n'est pas disponible, et déposé dans le réceptacle lorsque ce dernier est positionné sous le premier dispositif de préhension.

6. Procédé selon une des revendications précédentes, **caractérisé en ce que** le réceptacle (15) est déplacé au-dessus du niveau du stock (18) de couches de séparation (38), de préférence en surplomb du stock (18) de couches de séparation (38) de telle manière qu'une couche de séparation est soulevée du stock par le second dispositif de préhension (30) lorsque le réceptacle est éloigné, et déposée dans le réceptacle (15) lorsque ce dernier est positionné sous le second dispositif de préhension.

7. Procédé selon une des revendications 1 - 3, **caractérisé en ce que** le stock de couches de séparation (38, 138) est un réservoir de stockage (18, 118) pouvant être déplacé, en particulier à l'horizontale, sachant qu'il est déplacé de préférence entre la position permettant l'insertion des substrats (136) au-dessus des éléments de transport (114) pour substrats et la position permettant l'insertion de la couche de séparation (138) sous le second dispositif de préhension (130).

8. Procédé selon la revendication 7, **caractérisé en ce qu'**un des deux dispositifs de préhension (120, 130) est conduit à l'horizontale entre une position dans laquelle il se trouve au-dessus des éléments de transport (114) et une position dans laquelle il se trouve au-dessus du réceptacle (115), sachant que le réceptacle (115) est de préférence immobile au moins pendant son remplissage et que le réservoir de stockage (118) est déplacé au moins dans une position dans laquelle le second dispositif de préhension (130) peut extraire une couche de séparation (138) du réservoir de stockage (118).

9. Procédé selon la revendication 8, **caractérisé en ce que** le premier dispositif de préhension (120) est déplacé à l'horizontale et latéralement, sachant qu'il est déplacé de préférence entre une position permettant l'insertion du substrat (136) au-dessus des éléments de transport (114) pour les substrats et une position se trouvant sous le second dispositif de préhension (130).

10. Procédé selon une des revendications 7 à 9, **caractérisé en ce que** le second dispositif de préhension (130) est disposé au-dessus du premier dispositif de préhension (120) et saisit une couche de séparation (138) dans le réservoir de stockage (118), alors que les deux dispositifs de préhension, le réceptacle (115) et le réservoir de stockage sont disposés le long d'une ligne verticale.

11. Dispositif d'insertion de substrats plats dans un réceptacle à l'aide d'un procédé selon une des revendications précédentes, sachant que des couches de séparation (38, 138) sont insérées entre les substrats (36, 136) dans le réceptacle (15, 115), présentant
- des éléments de transport (14, 114) pour amener les substrats (36, 136) et un stock (18, 118) de couches de séparation,
- un premier dispositif de préhension (20, 120) pour la saisie, le déplacement et le dépôt des substrats et
- un second dispositif de préhension (30, 130) pour la saisie, le déplacement et le dépôt des couches de séparation,
sachant que les dispositifs de préhension sont conçus au moins pour un mouvement à la verticale, et sachant qu'au moins un des deux dispositifs de préhension est disposé de manière fixe à l'horizontale.

12. Dispositif selon la revendication 11, **caractérisé en ce que** le réceptacle (15, 115) est conçu de façon à pouvoir être déplacé à l'horizontale, sachant qu'il peut être déplacé en particulier au moins entre une position dans laquelle il se trouve sous le premier dispositif de préhension (20, 120) et une position dans laquelle il se trouve sous le second dispositif de préhension (30, 130).

13. Dispositif selon la revendication 11 ou 12, **caractérisé en ce que** les deux dispositifs de préhension (20, 120, 30, 130) sont fixés en position horizontale et peuvent être déplacés à la verticale.

14. Dispositif selon une des revendications 11 à 13, **caractérisé en ce qu'**une trajectoire de déplacement du réceptacle (15, 115) s'étend au-dessus des éléments de transport (14, 114), atteint de préférence au moins un point au-delà des éléments de transport, sachant en particulier que le premier dispositif de préhension (20, 120), le réceptacle (15, 115) dans cette position et les éléments de transport (14, 114) sont disposés essentiellement le long d'une ligne verticale les uns au-dessus des autres.

15. Dispositif selon une des revendications 11 à 14, **caractérisé en ce que** le réceptacle (15) peut être déplacé au-dessus du stock (18) de couches de séparation (38), sachant que la trajectoire de mouvement du réceptacle s'étend de préférence au moins au-delà du stock de couches de séparation et en particulier que le second dispositif de préhension (30), le réceptacle (15) dans cette position et le stock (18) sont disposés essentiellement le long d'une ligne verticale les uns au-dessus des autres.

16. Dispositif selon la revendication 15, **caractérisé en ce qu'**un dispositif de préhension (120, 130) peut être déplacé à l'horizontale entre une position dans laquelle il se trouve au-dessus des éléments de transport (114) disposés de manière fixe et une position dans laquelle il se trouve au-dessus d'un réceptacle (115), sachant que le réceptacle (115) est de préférence immobile et ne peut être déplacé pendant le remplissage.

17. Dispositif selon la revendication 16, **caractérisé en ce que** le stock est un réservoir de stockage (118) couplé mécaniquement au premier dispositif de préhension (120) pour un déplacement simultané, sachant que sont prévus des éléments d'entraînement conduisant le réservoir de stockage (118) et le premier dispositif de préhension (120) le long d'un rail de guidage (119) mécanique.

18. Dispositif selon la revendication 16 ou 17, **caractérisé en ce que** le second dispositif de préhension (130) est disposé à un niveau situé au-dessus du premier dispositif de préhension (120) de telle façon que le réservoir de stockage (118) puisse être déplacé entre les deux dispositifs de préhension.

19. Dispositif selon une des revendications 11 à 18, **caractérisé en ce que** les dispositifs de préhension (20, 120, 30, 130) présentent un support de base (22, 122, 32, 132) pouvant être déplacé en particulier latéralement à l'horizontale, sachant qu'est disposé sur le support de base un bras de préhension (21, 121, 31, 131) pouvant être déplacé verticalement et présentant des éléments de préhension (24, 124, 34, 134) dirigés vers le bas et que les éléments de préhension forment un niveau horizontal.
